# EUROPÄISCHE PATENTANMELDUNG

(11) **EP 1 758 178 A2**
(43) Veröffentlichungstag der Anmeldung: **28.02.2007**
(21) Anmeldenummer: 06017309.3
(22) Anmeldetag: 19.08.2006
(51) Int. Cl.: H01L 31/18, G01R 31/26

(54) **Verfahren und Vorrichtung zur Ermittlung von Produktionsfehlern in einem Halbleiterbauelement**

(30) Priorität: 23.08.2005 DE 102005040010
(71) Anmelder: SCHOTT Solar GmbH, 63755 Alzenau (DE)
(72) Erfinder: Nagel, Henning, Dr., 74199 Untergruppenbach (DE)
(74) Vertreter: Stoffregen, Hans-Herbert

(57) **Zusammenfassung**

Die Erfmdung bezieht sich auf ein Verfahren und eine Anordnung zur Ermittlung von Produktionsfehlern in einem Halbleiterbauelement durch Erzeugung von Überschussladungsträgern in dem Halbleiterbauelement und Bestimmung des elektrischen Potentials in diesem. Um mit einfachen Maßnahmen und ohne Beschädigung des Halbleiterbauelementes Produktionsfehler ermitteln zu können, wird vorgeschlagen, dass das Halbleiterbauelement zur Lumineszenz angeregt und deren ortsaufgelöste Intensitätsverteilung zur Ermittlung der ortsaufgelösten Verteilung des elektrischen Potentials in dem Halbleiterbauelement bestimmt wird.

## Beschreibung

Die Erfindung bezieht sich auf ein Verfahren zur Ermittlung von Produktionsfehlern in einem Halbleiterbauelement durch Erzeugung von Überschussladungsträgern in dem Halbleiterbauelement und Bestimmung des elektrischen Potentials in diesem. Ferner nimmt die Erfindung Bezug auf eine Anordnung zur Ermittlung von Produktionsfehlern in einem Halbleiterbauelement umfassend zumindest eine erste Einrichtung zur Erzeugung von Überschussladungsträgern in dem Halbleiterbauelement.

Ein Verfahren und eine Vorrichtung der eingangs genannten Art ist der US-B-6,750,662 zu entnehmen. Dabei wird die elektrische Potentialverteilung in dem Halbleiterbauelement mit Metallspitzen gemessen, die an mehreren Positionen einen elektrischen Kontakt mit der Halbleiteroberfläche herstellen. Zur Erzeugung der Überschussladungsträger wird entweder das Halbleiterbauelement mit Spannung beaufschlagt, also mit einem äußeren elektrischen Stromkreis beschaltet, oder einer elektromagnetischen Strahlung ausgesetzt.

Zur Bestimmung der ortsaufgelösten Verteilung des Potentials wird hierzu ein Draht kratzend über die Oberfläche des Halbleiterbauelementes bewegt, wodurch diese beschädigt wird. Dies ist insbesondere dann von Nachteil, wenn - wie üblich - auf der Oberfläche eine isolierende Antireflexschicht aufgebracht ist, die von der Nadel durchsetzt werden muss. Die hierdurch bedingte mechanische Beschädigung führt dazu, dass ein Einsatz für Solarzellen nicht geeignet ist. Losgelöst hiervon benötigen entsprechende Messungen relativ viel Zeit.

Um Produktionsfehler in einem elektrischen Leiter festzustellen, wird dieser mit einem fokussierten UV-Licht beaufschlagt, um sodann die Energie der aus dem Leiter heraustretenden Elektronen zu messen (US-A-4 967 152).

Um einen integrierten Schaltkreis berührungslos zu überprüfen, wird nach der EP-A- 0 216 077 die Photoelektronenemissionsspektroskopie eingesetzt.

Der vorliegenden Erfindung liegt die Aufgabe zu Grunde, ein Verfahren und eine Vorrichtung der eingangs genannten Art so weiterzubilden, dass mit einfachen Maßnahmen und ohne Beschädigung des Halbleiterbauelementes Produktionsfehler ermittelt werden können. Auch sollen die Messungen in kurzer Zeit durchgeführt werden können.

Zur Lösung der Aufgabe sieht die Erfindung verfahrensmäßig im Wesentlichen vor, dass das Halbleiterbauelement zur Lumineszenz angeregt und deren Intensitätsverteilung zur Ermittlung der Verteilung des elektrischen Potentials in dem Halbleiterbauelement bestimmt wird.

Die Bezeichnung Lumineszenz selbst steht für den allgemeinen Fall von Photolumineszenz oder Elektrolumineszenz für sich oder einer Kombination dieser. Bevorzugterweise wird erfindungsgemäß jedoch die Intensitätsverteilung der Elektrolumineszenz zur Bestimmung der ortsaufgelösten Potentialverteilung in dem Halbleiterbauelement benutzt.

Erfindungsgemäß erfolgt ein berührungsloses Messen der Potentialverteilung in dem Halbleiterbauelement, wobei die Messung selbst überaus schnell, ggfs. in Bruchteilen von Sekunden durchführbar ist.

Man macht sich die Kenntnis zu Eigen, dass eine hohe Ladungsträgerrekombinationsrate zu einer hohen Intensität führt. Eine hohe Ladungsträgerrekombination bedeutet jedoch, dass eine hohe Überschussladungsträgerdichte und damit ein hohes Potential besteht.

Zwar ist es bereits bekannt, die Lumineszenzintensität in Halbleiterbauelementen zu messen, um Inhomogenitäten in der effektiven Ladungsträgerlebensdauer zu bestimmen. Dabei kann die Lumineszenz entweder mit hochenergetischen Photonen (S. Ostapenko and M. Romero, Eur. Phys. J. Appl. Phys. 27, 2004, S. 55) oder durch Injektion von Überschussladungsträgern angeregt werden (T. Fuyuki, H. Kondo, T. Yamazaki, Y. Uraoka, (Applied Physics Letters 86, 2005, 5261108-1 - 262108-3). Im ersten Fall spricht man von Photolumineszenz, im letzten von Elektrolumineszenz. Nach T. Fuyuki et al. erfolgt eine ortsaufgelöste Intensitätsbestimmung der Lumineszenz, um Aussagen über die Diffusionslänge der Minoritätsladungsträger, also deren Lebensdauer und somit über die Qualität der Halbleiterschichten treffen zu können.

Aus den Lumineszenzintensitätsverteilungen werden jedoch keine Rückschlüsse auf das elektrische Potential, und zwar ortsaufgelöst gezogen, um insbesondere Fehler bezüglich der stromableitenden Leiterbahnen bei Solarzellen zu ermitteln, d. h. Leiterbahnunterbrechungen oder -einschnürungen bzw. die Leitfähigkeit von Leiterbahnen zu kontrollieren.

Auch ist es aus der Literaturstelle US.Z.: Applied Physics Letters, 2004, S. 4222 - 4224, bekannt, die Photolumineszenz einer Solarzelle gemittelt über die gesamte Solarzellenflächen zu messen, um hieraus das gemittelte elektrochemische Potential am pn-Übergang zu berechnen. Als Ergebnis wird eine Strom-Spannungs-Kurve der Solarzelle ohne ohmsche Verluste in den Kontaktleiterbahnen und am Metall-Halbleiter-Kontakt ermittelt, ohne dass hierdurch eine Kontrolle von Produktionsfehlern selbst ermöglicht wird.

Um die Überschussladungsträger, die zur Erzeugung der Lumineszenz notwendig sind, zu erzeugen, ist nach einem Vorschlag der Erfindung vorgesehen, dass das Halbleiterbauelement in einem äußeren elektrischen Kreis so geschaltet wird, dass die resultierenden elektrischen Potentialdifferenzen zu einer räumlich unterschiedlichen Ladungsträgerkonzentration und somit zu einer räumlich unterschiedlichen starken Lumineszenzintensität führen. Alternativ oder zusätzlich wird die Lumineszenz lokal oder großflächig mittels elektromagnetischer Strahlung angeregt.

Insbesondere ist vorgesehen, dass die Messung der Lumineszenzintensität im für die verwendeten Halbleiter geeigneten Wellenlängenbereich vorzugsweise mit einer Flächenkamera, Zeilenkamera oder einem rasternden Detektor durchgeführt wird. Die räumliche Lumineszenzintensitätsverteilung ist unter den gewählten Bedingungen ein direktes Maß für die räumliche elektrische Potentialverteilung.

Durch die erfindungsgemäße Lehre ergeben sich insbesondere Vorteile wie folgt:
- kurze Messzeiten von bis zu unter 0,5 sec;
- eine elektrische Kontaktierung ist nur an wenigen Stellen oder überhaupt nicht nötig. Daher sind grundsätzlich Beschädigungen der empfindlichen Halbleiteroberfläche ausgeschlossen;
- isolierende Schichten auf der Halbleiteroberfläche werden weder beschädigt noch sind solche zu entfernen, sofern diese für die Lumineszenzstrahlung transparent sind;
- durch Ausrichten bzw. Fokussierung des die Lumineszenzstrahlung erfassenden Detektors bzw. einer ggfs. vorhandenen Beleuchtung zur Erzeugung der Überschussladungsträger ist eine hohe Flexibilität bezüglich zu ermittelnder Messbereiche und Ortsauflösungen gegeben, so dass insbesondere Halbleiterbauelemente unabhängig von deren flächiger Erstreckung mit derselben Vorrichtung gemessen werden können.

In Weiterbildung der Erfindung ist vorgesehen, dass die Lumineszenzintensität bzw. deren räumliche Verteilung bei zumindest zwei voneinander abweichenden in dem Halbleiterbauelement herrschenden elektrischen Stormdichten gemessen und die Potentialverteilung in dem Halbleiterbauelement aus der Differenz der bei der jeweiligen elektrischen Stromdichte gemessenen Lumineszenzintensitätsverteilung bestimmt wird.

Um auf einfache Weise eine Ortsbestimmung vorhandener Fehler aufgrund der Lumineszenzintensitätsmessung und der sich hieraus unmittelbar ergebenden Potentialverteilung im Halbleiterbauelement zu ermöglichen, ist vorgesehen, dass die Lumineszenzintensitätsverteilung des Halbleiterbauelementes und dessen optische Abbildung überlagert werden.

Erfindungsgemäß wird die Lumineszenzintensitätsverteilung ortsaufgelöst gemessen und aus der ortsaufgelösten Lumineszenzintensitätsverteilung die flächige bzw. räumliche Verteilung des elektrischen Potentials in dem Halbleiterbauelement bestimmt. Dabei wird als Halbleiterbauelement insbesondere eine Solarzelle verwendet.

Insbesondere zeichnet sich die Erfindung durch ein Verfahren zur Überprüfung von Leiterbahnunterbrechung und/oder -einschnürung in einer Solarzelle bzw. der Überprüfung der elektrischen Leitfähigkeit von Leiterbahnen in einer Solarzelle aus, wobei die Solarzelle zur Lumineszenz, vorzugsweise Elektrolumineszenz angeregt wird und deren ortsaufgelöste Intensitätsverteilung zur Ermittlung der ortsaufgelösten Verteilung des elektrischen Potentials in der Solarzelle bestimmt wird. Aus der gemessenen Elektrolumineszenzverteilung wird erfindungsgemäß die Potentialverteilung bestimmt, wobei eine qualitative oder quantitative Bestimmung erfolgen kann. Grundsätzlich reicht jedoch eine qualitative Bestimmung aus, um fehlerhafte Leiterbahnen zu detektieren.

Erfindungsgemäß werden Rückschlüsse aus der Lumineszenzintensität auf die Potentialverteilung in der Solarzelle gezogen, wodurch wiederum Rückschlüsse auf fehlerhafte bzw. nicht ordnungsgemäß verschaltete Leiterbahnen gezogen werden können.

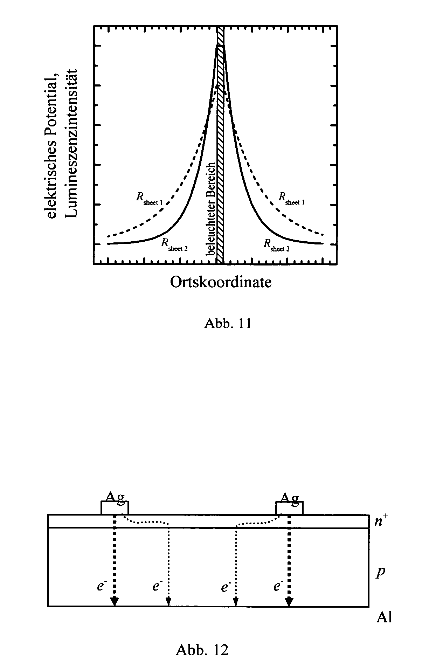

Die der Erfindung zugrunde liegenden physikalischen Prozesse sollen rein prinzipiell anhand der Abbildung 12 erläutert werden. Diese zeigt schematisch den Stromfluss in einer Solarzelle, die im Ausführungsbeispiel aus Ag bestehende Frontkontakte und einen aus A1 bestehenden Rückkontakt aufweist.

Durch ohmsche Verluste in der *n*⁺-diffundierten Schicht ist das elektrische Potential an den Ag-Kontakten auf der Vorderseite der Solarzelle am größten und fällt in Richtung der Mitte zwischen zwei Ag-Kontaktfingern ab. Deswegen ist die Stromdichte über den *pn*-Übergang in der Nähe der Vorderseitenkontakte am größten, in der Mitte zwischen den Vorderseitenkontakten am kleinsten. Die Konzentration der Überschussladungsträger (*e*⁻ im *p*-dotierten Gebiet) ist wiederum dort am größten, wo die Stromdichte am größten ist. Die strahlende Rekombinationsrate und somit die Lumineszenzintensität sind proportional zur Konzentration der Überschussladungsträger

Das erfindungsgemäße Verfahren ist vorzugsweise zur Überprüfung von Leiterbahnunterbrechungen und/oder -einschnürungen einer Solarzelle bzw. zur Überprüfung der elektrischen Leitfähigkeit von Leiterbahnen einer Solarzelle bestimmt.

Nach einem weiteren Vorschlag ist vorgesehen, dass das Halbleiterbauelement lokal beleuchtet und die räumliche Lumineszenzintensitätsverteilung in der Nähe der Beleuchtungsstelle gemessen wird. Ferner kann aus der räumlichen Lumineszenzintensitätsverteilung in der Nähe der Beleuchtungsstelle der Schichtwiderstand einer oder mehrerer leitfähiger Halbleiterschichten bestimmt werden.

Eine Anordnung der eingangs genannten Art zeichnet sich dadurch aus, dass dem Halbleiterbauelement oder einem oder mehreren Bereichen von diesem ein Lumineszenz des Halbleiterbauelements erfassender Detektor zugeordnet ist. Hierbei kann es sich insbesondere um eine CCD-Zeilen- oder -Matrixkamera handeln, die ggf. verstellbar zu dem Halbleiterbauelement angeordnet ist. Dies ist insbesondere dann von Vorteil, wenn großflächige Halbleiterbauelemente überprüft werden sollen, so dass nur eine Anordnung benutzt werden muss.

Das zu überprüfende Halbleiterbauelement ist des Weiteren mit einem äußeren Stromkreis zur Erzeugung der Überschussladungsträger beschaltet bzw. das Halbleiterbauelement ist zur Erzeugung des Überschussladungsträgers einer Beleuchtung ausgesetzt.

Weitere Einzelheiten, Vorteile und Merkmale der Erfindung ergeben sich nicht nur aus den Ansprüchen, den diesen zu entnehmen Merkmalen - für sich und/oder in Kombination -, sondern auch aus der nachfolgenden Beschreibung von der Zeichnung zu entnehmenden bevorzugten Ausführungsbeispielen.

Es zeigen:
- Abbildung 1: eine erste Ausführungsform einer Anordnung zur Erkennung und Lokalisierung von Produktionsfehlern in einem Halbleiterbauelement,
- Abbildung 2: ein Graustufenbild eines Bereichs des Halbleiterbauelements gemäß Abbildung 1,
- Abbildung 3: ein zweites Ausführungsbeispiel einer Anordnung zur Erkennung und Lokalisierung von Produktionsfehlern in einem Halbleiterbauelement,
- Abbildung 4: ein Bild eines Ausschnitts des Halbleiterbauelements gemäß Abbildung 3,
- Abbildung 5: ein Bild eines Ausschnitts einer multikristallinen Siliziumsolarzelle gemessen mit einer Anordnung gemäß Abbildung 3,
- Abbildung 6: eine weitere Ausführungsform einer Anordnung zur Erkennung und Lokalisierung von Produktionsfehlern in einem Halbleiterbauelement,
- Abbildung 7: eine vierte Ausführungsform einer Anordnung zur Erkennung und Lokalisierung von Produktionsfehlern in einem Halbleiterbauelement,
- Abbildungen 8 - 10: Abbildungen von Bereichen eines Halbleiterbauelements mit unterschiedlichen Lumineszenzintensitäten,
- Abbildung 11: einen ortsabhängigen Verlauf von Potential und Lumineszenzintensität in einem Halbleiterbauelement und
- Abbildung 12: eine Prinzipdarstellung eines Stromflusses in einer Solarzelle.

Den Abbildungen, in denen grundsätzlich gleiche Elemente mit gleichen Bezugszeichen versehen sind, sind rein prinzipiell Anordnungen zur Erkennung und Lokalisierung von Produktionsfehlern in Halbleiterbauelementen sowie Bilder von Lumineszenzverteilungen in den Halbleiterbauelementen zu entnehmen.

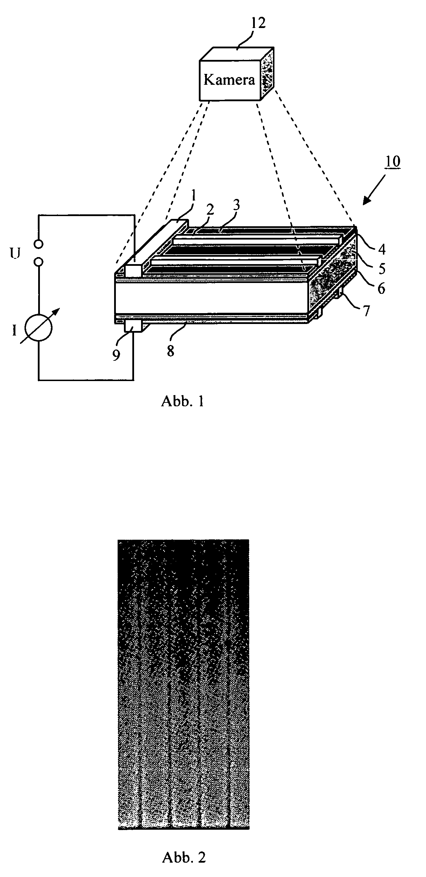

Eine erste Ausführungsform einer entsprechenden Anordnung ergibt sich rein schematisch aus der Abbildung 1. Mit dieser soll ein Halbleiterbauelement in Form einer monokristallinen Siliziumsolarzelle 10 bezüglich Produktionsfehler überprüft werden. Vorrangig werden dabei Produktionsfehler in Stromsammelschienen und in mit diesen verbundenen Stromleiterbahnen ermittelt.

In der Abbildung 1 weist die Solarzelle 10 auf der Vorder- und Rückseite metallene Stromsammelschienen 1, 9 sowie mit diesen verbundene dünnere und senkrecht zu den Stromsammelschienen 1, 9 verlaufende metallische Stromleiterbahnen 2, 7 auf.

Die Solarzelle 10 besteht z.B. aus einer ca. 250 µm dicken Siliziumscheibe 5 mit *p-*Dotierung, die auf der Vorderseite 4 ganzflächig *n*⁺ und auf der Rückseite 6 ganzflächig *p*⁺ diffundiert ist. Ferner sind auf der Vorder- und Rückseite 4, 6 Antireflexschichten 3, 8 insbesondere aus SiN aufgetragen.

Die Solarzelle 10 ist an den Stromsammelschienen 1, 9 elektrisch mit einer Spannungsquelle U und einem Strommessgerät I in Serie geschaltet. Oberhalb der Solarzelle 10 ist ein Detektor 12 angeordnet, der im Ausführungsbeispiel als Kamera mit einem gekühlten CCD-Chip ausgebildet ist. Die Empfindlichkeit der Kamera ist auf einen Wellenlängenbereich zwischen 700 nm und 1200 nm ausgelegt.

Um Produktionsfehler in dem im Ausführungsbeispiel als Solarzelle 10 ausgebildeten Halbleiterbauelement, insbesondere im Bereich der Stromsammelschienen 1, 9 und Stromleiterbahnen 2, 7 zu ermitteln, kann verfahrensmäßig wie folgt gehandelt werden.

Die Solarzelle 10 wird in Durchlassrichtung mit einer Spannung derart beaufschlagt, dass in der Solarzelle 10 Überschussladungsträger auftreten, die zur Lumineszenz führen, deren Intensität mit der Kamera 12 ortsaufgelöst gemessen werden, um hieraus die räumliche Verteilung des elektrischen Potentials in der Solarzelle 10 zu bestimmen, wodurch wiederum Rückschlüsse auf Produktionsfehler gezogen werden können.

Beispielhaft kann an einer monokristallinen Solarzelle mit ganzflächig metallisierter Rückseite und ohne Antireflexschicht auf der Rückseite eine Spannung von 0,62 V angelegt werden. Die Stromdichte durch die Solarzelle 10 beträgt 35 mA/cm² in Durchlassrichtung. Die Lumineszenzintensität eines Bereichs der Solarzelle 10 wird mit der der Abbildung 1 zu entnehmenden Vorrichtung ortsaufgelöst innerhalb von 0,8 s gemessen. Abbildung 2 zeigt das Ergebnis als Graustufenbild. Helle Bereiche entsprechen hoher Lumineszenzintensität, dunkle Bereiche niedriger. Die senkrecht verlaufenden dunklen Linien sind nicht den lumineszierenden dünnen metallischen Stromleiterbahnen auf der Solarzellenvorderseite zuzuordnen, also im Ausführungsbeispiel den Stromleiterbahnen 2. Am unteren Bildrand ist ein Teil der ebenfalls nicht lumineszierenden metallischen Stromsammelschiene 1 zu sehen. In unmittelbarer Nachbarschaft dieser metallischen Bereiche ist eine erhöhte Lumineszenzintensität der Solarzelle aufgrund von erhöhtem elektrischen Potential zu erkennen. Hellere Bereiche in Abbildung 2 entsprechend höherem elektrischen Potential, dunklere Bereiche niedrigem elektrischen Potential. Die Graustufen der Abbildung 2 sind in dem Gebiet außerhalb der metallischen Bereiche ein direktes Maß für das elektrische Potential. Der Grund für das erhöhte elektrische Potential in unmittelbarer Nachbarschaft zu den metallischen Bereichen sind ohmsche Verluste in der vorderen *n*⁺-diffundierten Schicht 4. Außerdem ist in der Abbildung 2 ein Anstieg des Potentials von oben nach unten zu beobachten, der darauf zurückzuführen ist, dass nur die untere Stromsammelschiene 1 elektrischen Kontakt mit dem äußeren Stromkreis aufweist. Die gemessene Potentialverteilung verdeutlicht, dass Produktionsfehler in dem überprüften Bereich der Solarzelle nicht vorliegen.

Die zuvor wiedergegebenen beispielhaften Zahlenwerte sind selbstverständlich in Abhängigkeit von dem zu überprüfenden Halbleiterbauelement zu variieren und somit als die Erfindung nicht einschränkend zu bewerten.

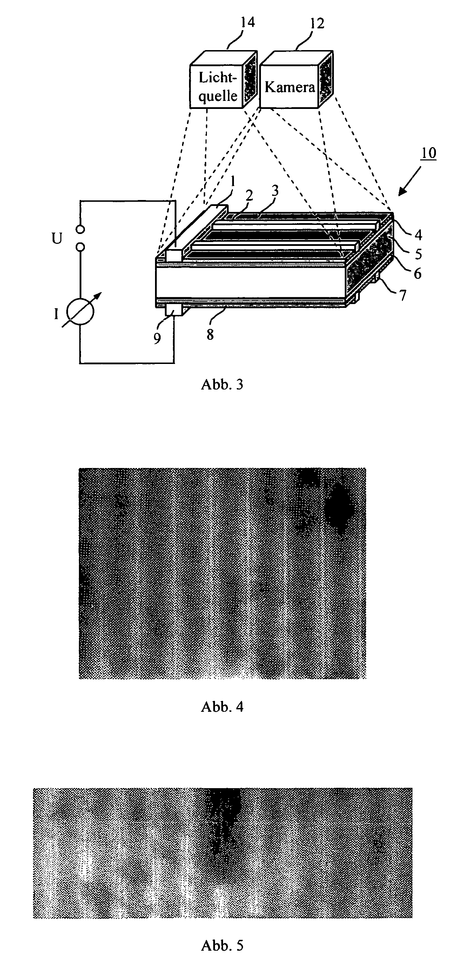

Der Abbildung 3 ist ein weiteres Ausführungsbeispiel einer Anordnung zur Erkennung und Lokalisierung von Produktionsfehlern in Halbleiterbauelementen zu entnehmen, wobei für die Abbildung 1 entsprechende Elemente gleiche Bezugszeichen verwendet werden.

Ergänzend zu dem zuvor erläuterten Verfahren wird die Solarzelle 10 während der Messung der Lumineszenzintensität mit einer Lichtquelle 14 beleuchtet. Hierdurch werden Ladungsträger in dem Halbleiter generiert, so dass sich dieselbe Potentialverteilung wie bei einer bestimmungsgemäßen Verwendung der Solarzelle 10 einstellt. Außerdem können reflektierende Bereiche wie z.B. die metallischen Stromleiterbahnen 1, 2 kenntlich gemacht werden, wenn die Kamera 12 im Wellenlängenbereich des reflektierten Lichts empfindlich ist. In diesem Fall erhält man eine Überlagerung des optischen Bilds mit der räumlichen Lumineszenzintensitätsverteilung. Dies ermöglicht die einfache Unterscheidung zwischen Halbleiterbereich mit niedriger Lumineszenzintensität und Bereichen, auf denen sich für die Lumineszenzstrahlung nicht transparente Bereiche wie z.B. die metallischen Stromleiterbahnen 1,2 befinden.

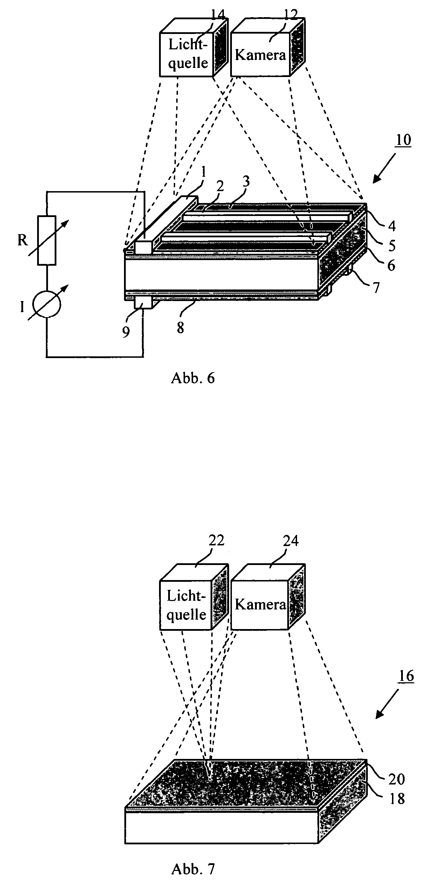

Bei der Anordnung gemäß Abbildung 3 ist es nicht zwingend erforderlich, dass die Solarzelle 10 mit dem die Spannungsquelle U enthaltenden äußeren elektrischen Stromkreis verbunden ist. Dies entspricht einer Ausführungsform der Abbildung 6, wobei sich in dem äußeren Stromkreis ein regelbarer Widerstand R befindet. Der Strom selbst wird von der Solarzelle 10 generiert. Grundsätzlich sollte jedoch eine Spannungsbeaufschlagung erfolgen, um im hinreichenden Umfang Überschussladungsträger und damit die zur Messung erforderliche Lumineszenz zu generieren.

Die der Abbildung 3 prinzipiell zu entnehmende Anordnung wurde benutzt, um eine multikristalline Siliziumsolarzelle bezüglich Produktionsfehler zu überprüfen. Hierzu wurde eine Spannung von 0,62 V angelegt, wobei die Siliziumsolarzelle eine ganzflächig metallisierte Rückseite ohne Antireflexschicht aufwies. Die Stromdichte durch die Solarzelle betrug 30 mA/cm² in Durchlassrichtung.

Abbildung 4 zeigt das mit einer im Wellenlängenbereich zwischen 300 nm und 1200 nm empfindlichen CCD Kamera aufgenommene Bild. Die Zusatzbeleuchtung hat in diesem Beispiel eine so schwache Intensität, dass die Photogenerationsrate der Ladungsträger im Halbleiter vernachlässigt werden kann. Daher ergibt sich eine vergleichbare Potentialverteilung entsprechend der Abbildung 2, die auf einen fehlerfreien Produktionsprozess hindeutet. Zusätzlich erscheinen die metallischen Stromleiterbahnen 2 auf der Vorderseite der Solarzelle hell, da diese das sichtbare Licht stärker reflektieren als das antireflexbeschichtete Silizium der Vorderseite 4 zwischen den Stromleiterbahnen 2. Hierdurch ergibt sich der Vorteil, dass sich Bereiche mit reduzierter effektiver Ladungsträgerlebensdauer, in denen die Überschussladungsträgerdichte reduziert ist und die daher eine geringe Lumineszenzintensität zeigen, von den Bereichen gut unterscheiden lassen, die von den Stromleiterbahnen 2 abgedeckt sind. Im multikristallinen Silizium sind Bereiche mit reduzierter effektiver Ladungsträgerlebensdauer regelmäßig anzutreffen. Ein entsprechendes Gebiet ist in Abbildung 4 oben rechts erkennbar.

Der Abbildung 5 ist ein Bild einer multikristallinen Siliziumsolarzelle zu entnehmen, die unter den gleichen Bedingungen wie zuvor erläutert gemessen worden ist. Die elektrische Kontaktierung befindet sich an einer nicht sichtbaren Stromsammelschiene am unteren Bildrand. Der dunkle Bereich in der Mitte der Abbildung 5 entspricht einem Gebiet mit niedrigem elektrischen Potential aufgrund einer mit bloßem Auge kaum sichtbaren Unterbrechung einer der mittleren Stromleiterbahnen 2. Die Stromleiterbahn 2 selbst ist wegen der zusätzlichen Beleuchtung als helle Linie im dunklen Bereich gut erkennbar.

Der Abbildung 7 ist eine weitere Prinzipdarstellung eines Ausführungsbeispiels einer erfindungsgemäßen Anordnung zur Erkennung und Lokalisierung von Produktionsfehlern in Halbleiterbauelementen zu entnehmen. Im Ausführungsbeispiel handelt es sich bei dem Halbleiterbauelement 16 um eine kristalline Siliziumscheibe 18, die *p*-dotiert ist und auf der Vorderseite 20 ganzflächig *n*⁺-diffundiert ist. Eine fokussierte Lichtquelle 22, idealerweise ein Laser, generiert lokal Überschussladungsträger, so dass in dem beleuchteten Gebiet wegen der ladungsträgertrennenden Eigenschaften des *pn-*Übergangs ein erhöhtes elektrisches Potential herrscht. Wegen ohmscher Verluste in der *n*⁺-diffundierten Schicht 20 fällt das Potential außerhalb des beleuchteten Gebiets ab. Aus der mit einer Kamera 24 wie CCD-Matrix oder -Zeilenkamera gemessenen räumlichen Lumineszenzintensitätsverteilung wird die Potentialverteilung um das beleuchtete Gebiet herum bestimmt. Daraus ergibt sich der Schichtwiderstand der *n*⁺-diffundierten Schicht 20. Durch Abrastern der gesamten Siliziumscheibe 16 kann der Schichtwiderstand ortsaufgelöst gemessen werden. Somit verdeutlicht das Beispiel, dass mit der erfindungsgemäßen Lehre auf einfache und ideale Weise eine berührungslose Qualitätskontrolle von thermischen Prozessen zur Eindiffusion von Dotierstoffen ermöglicht wird.

Sofern entsprechend der Abbildungen 3, 6 und 7 zur Generation von Überschussladungsträgern in Halbleitern Lichtquellen wie die Lichtquellen 14, 22 zum Einsatz gelangen, wird typischerweise eine hohe Intensität dieser von > 500 W/m² verwendet. Der Wellenlängenbereich sollte außerhalb (meist unterhalb) des Wellenlängenbereichs der Lumineszenz liegen, damit der Luminszenzdetektor von diesem Licht nicht gestört wird. Evt1. wird vor den Detektor ein optischer Bandpassfilter mit großer Transmission im Wellenlängenbereich der Lumineszenz und sehr niedriger Transmission außerhalb dieses Bereichs angebracht. Siliziumsolarzellen lumineszieren mit hoher Intensität im Wellenlängenbereich zwischen 1000 und 1300 nm. Messbar ist die Lumineszenz von Silizium zwischen 440 und 1800 nm. Typischerweise wird Licht mit Wellenlängen zwischen 300 und 850 nm für die Generation von Überschussladungsträgern verwendet, zumal der Absorptionskoeffizient von Silizium in diesem Bereich sehr groß ist. Zur lokalen Generation von Überschussladungsträgern (Lichtquelle 22) ist ein Helium-Neon-Laser mit einer Wellenlänge von 632,8 nm gut geeignet.

Sofern entsprechend der Abbildung 3 und 6 die Lichtquelle nur zur Überlagerung des optischen Bilds dient, wird eine sehr geringe Intensität verwendet, z. B. 0, 5 W/m². Für den Wellenlängenbereich gilt als einzige Bedingung, dass die Kamera empfindlich genug sein muss. Also z. B. Neonröhrenlicht oder Halogenlampenlicht mit Wellenlängen größer 200 nm bei den für Siliziumsolarzellen verwendeten Kameras.

Aufgrund der erfindungsgemäßen Lehre besteht auch die Möglichkeit, aus der räumlichen Lumineszenzintensitätsverteilung den Schichtwiderstand einer oder mehrerer leitfähiger Halbleiterschichten zu bestimmen. Nimmt man z.B. ein Bauelement gemäß Abbildung 7, so haben das elektrische Potential und die Lumineszenzintensität bei lokaler Beleuchtung einen Verlauf, der sich aus der Abbildung 11 ergibt. Dabei stehen *R*_{sheet 1} und *R*_{sheet 2} für verschieden große Schichtwiderstände der *n*⁺-diffundierten Schicht, wobei *R*_{sheet 1} < *R*_{sheet 2} angenommen wurde. Je steiler der Abfall des elektrischen Potentials außerhalb des beleuchteten Bereichs, desto größer der Schichtwiderstand. Das elektrische Potential wird aus der Lumineszenz ermittelt.

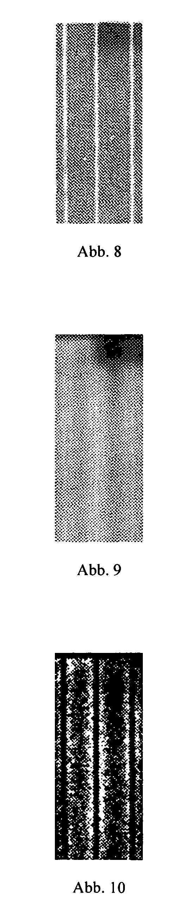

Weitere Messmöglichkeiten zur Erkennung und Lokalisierung von Produktionsfehlern in Halbleiterbauelementen sollen anhand der Abbildungen 8 bis 10 erläutert werden. So ist der Abbildung 8 die Lumineszenzintensität eines Bereichs einer multikristallinen Siliziumsolarzelle bei einer niedrigen Stromdichte von 10 mA/cM² zu entnehmen, wobei die Lumineszenzintensität selbst in einer Anordnung entsprechend der Abbildung 1 gemessen wurde. Mit der gleichen Anordnung wurde sodann die Lumineszenz derselben multikristallinen Siliziumsolarzelle bei einer hohen Stromdichte von 50 mA/cm² gemessen (Abbildung 9). Die Spannungsbeaufschlagung der multikristallinen Siliziumsolarzelle erfolgte dabei in Durchlassrichtung. Die zur Messung benutzte Solarzelle besaß eine ganzflächig metallisierte Rückseite, die aus Aluminium und lokal aus Silber zum Anlöten von Verbindern bestand. Bei niedriger Stromdichte ist die Potentialänderung im Bereich zwischen den senkrecht verlaufenden Stromleiterbahnen vernachlässigbar (Abbildung 8), während diese bei hohen Stromdichten deutlicher hervortritt (Abbildung 9). Letzteres wird durch den vom *pn*-Übergang hervorgerufenen exponentiellen Zusammenhang zwischen Potential und Lumineszenzintensität verstärkt. Im Bereich der Silberlötinseln, der in der Abbildung 9 oben rechts zu sehen ist, wird die gemessene Potentialverteilung vom Einfluss der in diesem Bereich reduzierten effektiven Ladungsträgerlebensdauer überlagert. Dies bedeutet, dass Bereiche mit niedriger effektiver Ladungsträgerlebensdauer mit Bereichen verwechselt werden könnten, in denen das elektrische Potential niedrig ist. Um diese Verwechslung auszuschließen, kann erfmdungsgemäß die räumliche Potentialverteilung in der Solarzelle unabhängig von der effektiven Ladungsträgerlebensdauer bestimmt werden, indem die Grauwerte der bei hoher und niedriger Stromdichte aufgenommenen Bilder punktweise voneinander subtrahiert werden. Das Ergebnis ist der Abbildung 10 zu entnehmen. Diese zeigt die um die Auswirkung der effektiven Ladungsträgerlebensdauer korrigierte räumliche elektrische Potentialverteilung. Man erkennt, dass die im Bereich der Silberlötinseln in den Abbildungen 8 und 9 eine unterschiedliche Lumineszenz zeigenden Bereiche keine Produktionsfehler aufweisen.

## Patentansprüche

1. Verfahren zur Ermittlung von Produktionsfehlern in einem Halbleiterbauelement, wie Solarzelle, durch Erzeugung von Überschussladungsträgern in dem Halbleiterbauelement und Bestimmung des elektrischen Potentials in diesem,
**dadurch gekennzeichnet,**
**dass** das Halbleiterbauelement zur Lumineszenz angeregt und deren ortsaufgelöste Intensitätsverteilung zur Ermittlung der ortsaufgelösten Verteilung des elektrischen Potentials in dem Halbleiterbauelement bestimmt wird.

2. Verfahren nach Anspruch 1,
**dadurch gekennzeichnet,**
**dass** die Lumineszenzintensität mittels eines Sensors wie CCD-Kamera, insbesondere einer CCD-Matrix oder CCD-Zeilenkamera, ermittelt wird.

3. Verfahren nach Anspruch 1,
**dadurch gekennzeichnet,**
**dass** zur Erzeugung der Überschussladungsträger das Halbleiterbauelement mit elektrischer Spannung und/oder mit elektromagnetischer Strahlung beaufschlagt wird.

4. Verfahren nach zumindest Anspruch 1,
**dadurch gekennzeichnet,**
**dass** die Lumineszenzintensität bzw. deren Verteilung bei zumindest zwei zueinander abweichenden in dem Halbleiterbauelement herrschenden elektrischen Stromdichten gemessen und die Potentialverteilung in dem Halbleiterbauelement aus der Differenz der bei den jeweiligen elektrischen Stromdichten gemessenen Lumineszenzintensitätsverteilungen bestimmt wird.

5. Verfahren nach zumindest Anspruch 1,
**dadurch gekennzeichnet,**
**dass** die Lumineszenzintensitätsverteilung des Halbleiterbauelements und dessen optische Abbildung zur Bestimmung der elektrischen Potentialverteilung auf bzw. in dem Halbleiterbauelement überlagert werden.

6. Verfahren nach zumindest Anspruch 1,
**dadurch gekennzeichnet,**
**dass** die Lumineszenzintensität ortsaufgelöst gemessen wird.

7. Verfahren nach zumindest Anspruch 6,
**dadurch gekennzeichnet,**
**dass** aus der ortsaufgelösten Lumineszenzintensitätsverteilung flächige oder räumliche Verteilung des elektrischen Potentials in dem Halbleiterbauelement bestimmt wird.

8. Verfahren nach Anspruch 1 zur Überprüfung von Unterbrechung und/oder Einschnürung und/oder elektrischer Leitfähigkeit einer oder mehrerer Leiterbahnen einer Solarzelle.

9. Verfahren nach zumindest einem der vorhergehenden Ansprüche,
**dadurch gekennzeichnet,**
**dass** das Halbleiterbauelement lokal zur Lumineszenz angeregt wird und aus gemessener räumlicher Lumineszenzintensitätsverteilung das elektrische Potential zur Ermittlung des Schichtwiderstandes einer oder mehrerer leitfähiger Schichten des Halbleiterbauelements bestimmt wird.

10. Verfahren zur Überprüfung von Leiterbahnen einer Solarzelle umfassend die Schritte:
- in der Solarzelle werden durch Beaufschlagen mit einer elektrischen Spannung oder durch Beaufschlagen mit elektromagnetischer Strahlung Überschussladungsträger erzeugt,
- es wird eine ortsaufgelöste Verteilung der Lumineszenz ermittelt, die durch die Überschussladungsträger in der Solarzelle erzeugt werden,
- aus der ortsaufgelösten Verteilung der Lumineszenz wird eine ortsaufgelöste Verteilung des elektrischen Potentials in der Solarzelle bestimmt, die Rückschlüsse über Verlauf und/oder Leitfähigkeit der Leiterbahnen ermöglichen.

11. Anordnung zur Ermittlung von Produktionsfehlern in einem Halbleiterbauelement (10, 16) wie Solarzelle, umfassend zumindest eine erste Einrichtung (U, 14) zur Erzeugung von Überschussladungsträgern in dem Halbleiterbauelement, zur Durchführung des Verfahrens nach zumindest Anspruch 1,
**dadurch gekennzeichnet,**
**dass** dem Halbleiterbauelement (10, 16) oder zumindest einem Bereich von diesem ein Lumineszenz des Halbleiterbauelements erfassender Detektor (12, 24) zugeordnet ist.

12. Anordnung nach Anspruch 11,
**dadurch gekennzeichnet,**
**dass** der Detektor (12, 24) wie eine CCD-Zeilen- oder -Matrixkamera zu dem Halbleiterbauelement (10, 16) verstellbar angeordnet ist.

13. Anordnung nach Anspruch 11,
**dadurch gekennzeichnet,**
**dass** das Halbleiterbauelement (10, 16) mit einem äußeren Stromkreis (U) zur Erzeugung von Überschussladungsträgern beschaltet ist und/oder dem Halbleiterbauelement (10, 16) zur Erzeugung von Überschussladungsträgern eine Beleuchtungsquelle (40, 42) zugeordnet ist.
